Europäisches Patentamt

European Patent Office

Office européen des brevets

(11) Publication number: **0 523 734 A1**

# EUROPEAN PATENT APPLICATION

(21) Application number: **92112263.6**

(22) Date of filing: **17.07.92**

(51) Int. Cl.5: **G01R 31/28**

(30) Priority: **19.07.91 JP 179774/91**
**29.07.91 JP 189019/91**
**29.07.91 JP 189022/91**
**30.07.91 JP 190013/91**

(43) Date of publication of application:
**20.01.93 Bulletin 93/03**

(84) Designated Contracting States:
**CH DE FR GB IT LI NL**

(71) Applicant: **SUMITOMO ELECTRIC INDUSTRIES, LIMITED**
**5-33, Kitahama 4-chome Chuo-ku**
**Osaka(JP)**

(72) Inventor: **Hashinaga, Tatsuya, c/o Yokohama Works**
**Sumitomo Elec. Ind., Ltd., 1, Taya-cho**
**Sakae-ku, Yokohama-shi, Kanagawa(JP)**
Inventor: **Nishiguchi, Masanori, c/o Yokohama Works**
**Sumitomo Elec. Ind., Ltd., 1, Taya-cho**
**Sakae-ku, Yokohama-shi, Kanagawa(JP)**

(74) Representative: **Lehn, Werner, Dipl.-Ing. et al**
**Hoffmann, Eitle & Partner Patentanwälte**
**Arabellastrasse 4**
**W-8000 München 81(DE)**

(54) **Burn-in apparatus and method.**

(57) A burn-in apparatus for use in burn-in tests includes a burn-in test container (6) for accommodating a plurality of semiconductor device. Also, the burn-in apparatus includes measuring means for individually measuring junction temperatures of semiconductor chips (7) of the respective semiconductor device by detecting electric characteristics of temperature sensors (72) built in the semiconductor chips, and temperature adjusting means (8) for controlling amounts of heat radiation and conduction of the semiconductor chips. The temperature adjusting means (8), such as means for controlling air flow rates of air nozzles of the container, is controlled by control means on the basis of outputs of the measuring means. Thus, the junction temperatures can be kept within a predetermined temperature range to thereby improve the accuracy of screening tests.

Fig. 3

## Background of the Invention

(Field of the Invention)

This invention relates to a burn-in apparatus and method, more specifically for use in burn-in tests (in high temperature continuous operations) in which temperature loads and electric loads are applied to semiconductor devices to be tested.

(Related Background Art)

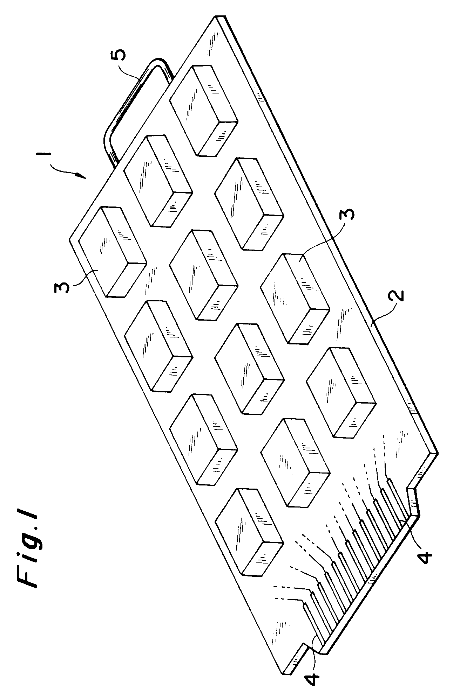

Burn-in apparatuses are essential to the estimation of lives of semiconductor devices and the detection of early failures thereof in their screening steps. Generally a burn-in test is conducted in the following way. FIG. 1 is a perspective view of a burn-in board 1. On a board 2 of a heat-resistant resin or others there are provided a plurality of sockets 3 for semiconductor devices-to-be-tested (not shown, DUT (Device under Test)) to be received in, and on one end of the board 2 there are provided external terminals 4 for the electric contact with the outside. A handle 5 is provided on the other end of the board 2 for the manipulation of the burn-in board 1 by operators. The terminals (not shown) of the sockets 3 are connected to the external terminals 4 by wiring (partially shown) on the board 2.

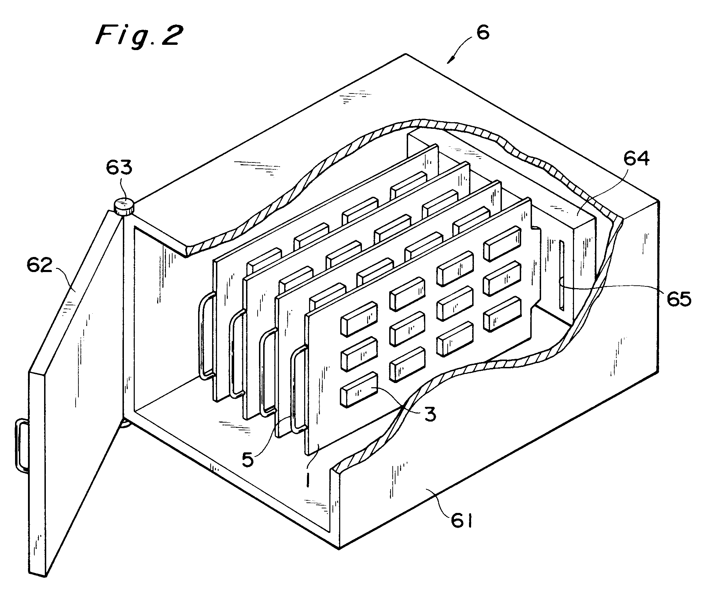

Such burn-in boards 1 are set in a burn-in test chamber 6 as shown in FIG. 2. The burn-in test chamber 6 is constituted by a case 61 as the main body, and a lid 62 which are connected to the case 61 by a hinge mechanism. The burn-in boards 1 are inserted in insertion slits 65 formed in a board connector 64 provided inside the chamber 6 to connect the external terminals 4 to terminals (not shown) of the board connector 64.

In the conventional burn-in tests, an internal temperature of the burn-in test chamber 6, i.e., an environmental temperature, of semiconductor devices to be tested, is measured by a temperature sensor disposed near the inside of the wall of the case 61, and a measured temperature is monitored to control temperature adjusting means (MIL-STD 883, MIL-STD 750).

But the conventional art has not been able to conduct burn-in tests properly for the following reasons. That is, in the conventional art, what can be monitored real time is an environmental temperature Ta of devices to be tested, and the environmental temperature does not agree with surface temperatures of the semiconductor chips, especially junction temperatures Tj at the pn junctions or the Schottky junctions. For the efficient estimation of lives of semiconductor devices and the efficient detection of initial failures of semiconductor devices without applying overloads to proper devices, it is preferable to conduct burn-in tests within a set junction temperature Tj range. Conventionally in conducting a burn-in test, a junction temperature Tj is estimated based on a measurement result of an environmental temperature Ta. But it needs very complicated operations to find relationships between environmental temperature Ta and junction temperatures Tj, and depending on sizes, types, specifications and so on of semiconductor devices, the estimation of the junction temperatures needs different operations. Consequently it has been difficult to conduct burn-in tests easily and with high precision.

## Summary of the Invention

An object of this invention is to provide a burn-in test device and method which can control with high precision temperatures of the chips themselves of semiconductor devices to be tested, and can improve yields of screening tests.

The burn-in apparatus according to this invention comprises a burn-in test chamber for accommodating a plurality of mounts (e.g., printed boards with sockets) for devices-to-be-tested including semiconductor chips with temperature sensors (e.g., Schottky junction diodes) built in, temperature adjusting means for adjusting an ambient air temperature (e.g., a heater and a blower), temperature detecting means (e.g., a plurality of variable power sources and a plurality of current detectors) for individually measuring temperatures of the respective semiconductor chips based on electric characteristics monitored by the temperature sensors, and control means (e.g., a microprocessor and peripheral units) for controlling the temperature adjusting means, based on measurement results of the temperature detecting means.

The described above burn-in apparatus according to this invention further comprises power supplying control means (e.g., a plurality of variable power sources) for supplying an electric power to the semiconductor devices to be tested, and control means for controlling the power supplying control means.

In this invention, the temperature detecting means performs the detection not by the conversion of environmental temperatures inside the burn-in test chamber into junction temperatures of the respective semiconductor chips, but direct measurement of the junction temperatures, with the result that the junction temperatures can be measured with high accuracy. The control means receives thus-measured values, processes the input measured values in accordance with a preset procedure, gives instructions to the temperature adjusting means to control temperatures inside the burn-in test chamber, or otherwise gives instructions to the power supplying control means to control applying voltages to the respective devices to be tested.

The above-described burn-in apparatus uses measured junction temperatures of high accuracy to control a burn-in test. Consequently variations of a burn-in environment of the respective semiconductor devices-to-be-tested due to their mounting conditions can be made smaller, and unintended overloads to the devices can be prevented. Accordingly burn-in tests with high precision and screening with improved yields can be conducted.

The burn-in method according to this invention comprises:

1) the step of deriving a parameter for converting electric characteristics of the temperature sensors of the semiconductor chips built in a plurality of semiconductor devices-to-be-tested to junction temperatures;

2) the step of measuring junction temperatures of the respective semiconductor chips in test chamber using the parameters;

3) the step of adjusting the temperature inside the burn-in test chamber and/or feeding the current, based on measured junction temperatures;

4) the steps 2 and 3 being repeated, or the step of ending the current burn-in test operation when a condition for ending a burn-in test operation according to the processing procedure stored in the control device is detected.

The above-described burn-in method uses directly measured values of junction temperatures of the respective semiconductor devices-to-be-tested to control a burn-in test. Consequently variations of a burn-in environment of the respective semiconductor devices-to-be-tested due to their mounting conditions can be made smaller, and unintended overloads to the devices can be prevented. Accordingly burn-in tests with high precision and screening with improved yields can be conducted.

The present invention will become more fully understood from the detailed description given hereinbelow and the accompanying drawings which are given by way of illustration only, and thus are not to be considered as limiting the present invention.

Further scope of applicability of the present invention will become apparent from the detailed description given hereinafter. However, it should be understood that the detailed description and specific examples, while indicating preferred embodiments of the invention, are given by way of illustration only, since various changes and modifications within the spirit and scope of the invention will become apparent to those skilled in the art form this detailed description.

## Brief Description of the Drawings

FIG. 1 is a perspective view of a burn-in board;

FIG. 2 is a perspective view of a burn-in test chamber;

FIG. 3 is a diagrammatic view of the burn-in apparatus according to one embodiment of this invention;

FIG. 4A is a perspective view of a semiconductor chip used in the embodiment;

FIG. 4B is a graph of a characteristic of a temperature detecting diode used in the embodiment;

FIG. 5 is a flow chart of a first junction temperature measuring method used in the embodiment;

FIG. 6 is a flow chart of a second junction temperature measuring method used in the embodiment;

FIG. 7 is a perspective view of a socket used in the embodiment;

FIG. 8 is a sectional view of the socket;

FIG. 9 is a flow chart of the burn-in method according to a first embodiment of this invention;

FIG. 10 is a flow chart of the burn-in method according to another embodiment of this invention; and

FIG. 11 is a graph of an experimental result of a relationship between TC value and n value.

## Description of the Preferred Embodiment

An embodiment of this invention will be explained with reference to the drawings attached hereto.

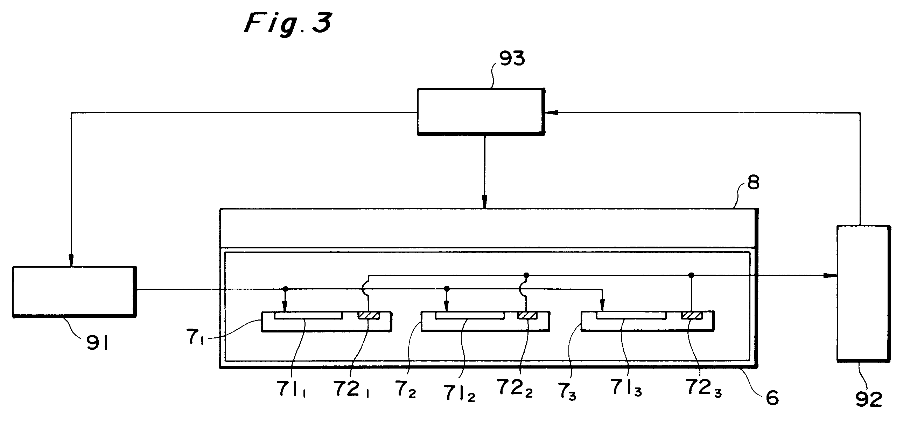

FIG. 3 is a block diagram of the burn-in test apparatus according to one embodiment of this invention. As shown in FIG. 3, semiconductor devices (not shown) with semiconductor chips $7_1$, $7_2$, $7_3$ built in are set in the burn-in test chamber 6. On each of the semiconductor chips $7_1$, $7_2$, $7_3$ there are formed an integrated circuit $71_1$, $71_2$, $71_3$, and temperature detecting diodes $72_1$, $72_2$, $72_3$ as temperature sensors. Temperature adjusting means 8 is provided on the burn-in test chamber 6 for supplying heated air or heating by heater means. The integrated circuits $71_1$, $71_2$, $71_3$ of the respective semiconductor chips $7_1$, $7_2$, $7_3$ are supplied with an electric load from power supplying means 91. Electric characteristics (especially changes of a forward voltage (a threshold value) $V_F$) of the respective temperature detecting diodes are $72_1$, $72_2$, $72_3$ individually monitored to measure junction temperatures Tj of the respective semiconductor chips 71 - 73.

This temperature measurement is conducted in the following way.

In measuring electric characteristics of the temperature detecting diode 72, a junction temperature of the temperature detecting diode 72 is measured. The heat resistance of the semiconductor chip 7 is sufficiently smaller than heat resistances of its ambient substances (air, or molding materials), and the following relationships are given.

(A junction temperature of the temperature detecting diode 72) ≈ (A junction temperature of the integrated circuit 71) = Tj

Hereinafter both junction temperatures are represented commonly by Tj.

This junction temperature Tj is measured by the following burn-in apparatus and method according to this invention.

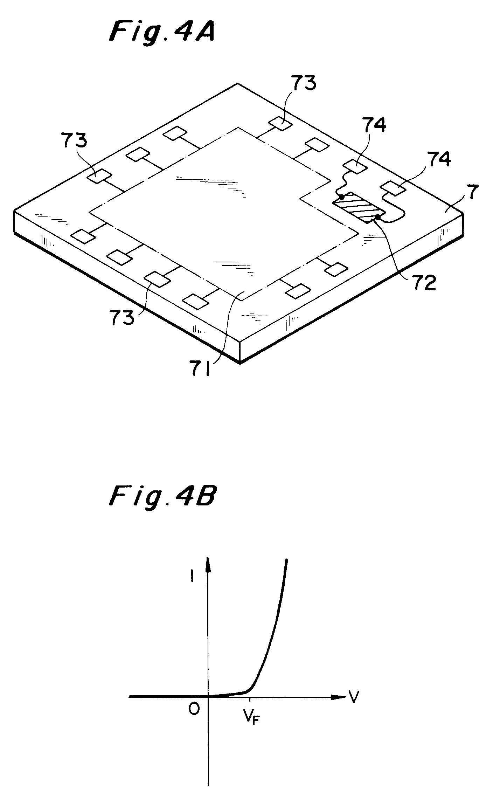

FIG. 4A shows a diagrammatic perspective view of the semiconductor chip 7 used in the above-described embodiment, and FIG. 4B shows an I-V characteristic of the temperature detecting diode 72. As shown in FIG. 4A, on the semiconductor chip 7 there are formed an integrated circuit 71, a temperature detecting diode 72, feeding pads 73 connected to the integrated circuit 71, and monitor pads 74 connected respectively to the anode and the cathode of the temperature detecting diode 72. Such semiconductor chip 7 is packaged in a flat package or in a leadless chip carrier (LCC), and a semiconductor device to be tested is prepared. The temperature monitor of such semiconductor chip 7 is conducted by observing an I-V characteristic of the temperature detecting diode 72. The forward voltage $V_F$ of the I-V characteristic of FIG. 4B changes substantially linearly with respect to junction temperatures in a range of junction temperatures exhibited in a burn-in test of the semiconductor device. This relationship is approximately expressed by the following Formula 1.

$$V_F \approx TC \bullet Tj + V_{FO} \qquad (1)$$

$V_F$ : Forward voltage of a temperature detecting diode

TC : Temperature coefficient of $V_F$ value

Tj : Junction temperature of a semiconductor device to be tested

$V_{FO}$ : Constant given for each semiconductor device to be tested

A current flowing through the temperature detecting diode 72 when a threshold value $V_F$ is applied thereto is so trivial that the temperature detecting diode does not contribute much to increases of a junction temperature. When the forward voltage $V_F$ is measured with the integrated circuit 71 unfed, a junction temperature Tj agrees with an environmental temperature.

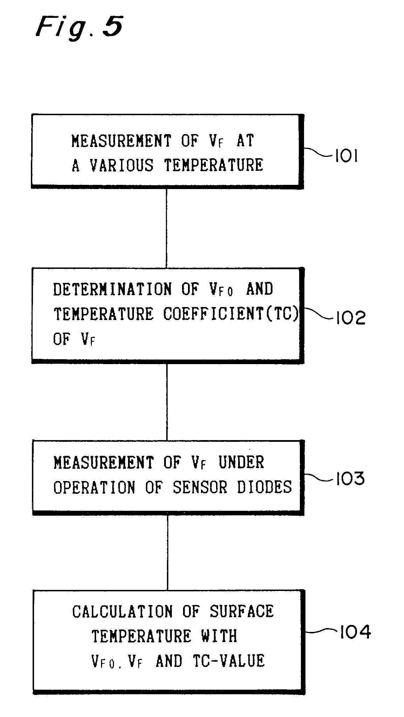

A first temperature measurement technique uses the above-described property, and the flow chart of this technique is shown in FIG. 5. First, values of a forward voltage $V_F$ are measured at different environmental temperatures with the integrated circuit 71 unfed (Step 101). Based on the measured values of the forward voltage, and Formula 1, a value of a constant $V_{FO}$, and a value of a temperature coefficient TC of the threshold values $V_F$ are given (Step 102). Following this preparation, a burn-in test is started, and during the burn-in, temperatures of the semiconductor chips 7 are accurately detected. That is, semiconductor chips 7 are mounted on the burn-in apparatus, and while the integrated circuits 71 are in operation with a current supplied to, values of the forward voltages $V_F$ are measured (Step 103). Values of the junction temperatures Tj are given based on the value of the constant $V_{FO}$, the value of the temperature coefficient TC, and measured values of threshold values $V_F$ (Step 104).

The following second junction temperature measurement technique can give measured values of precision as high as the first technique.

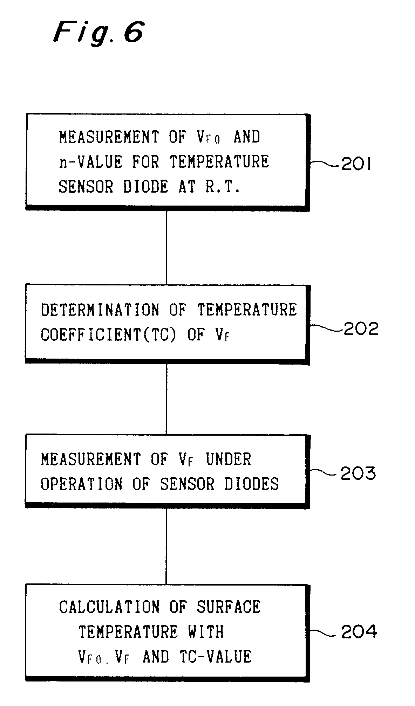

FIG. 6 shows the flow chart of the second junction temperature measurement technique. First, a value of a constant $V_{FO}$ of a temperature detecting diode 72 formed on the semiconductor chip 7, and an ideal value n thereof are given at the room temperature (Step 201). Here a forward current $I_F$ of the Schottky temperature detecting diode 72 is given by the following Formula 2.

$$I_F \approx SA^* T^2 exp\left(-\frac{q\phi_B}{kT}\right) exp\left(\frac{qV_F}{nkT}\right) \qquad \cdots\cdots\cdots (2)$$

4

S :      Schottky junction area
A*:      Effective Richardson constant
T :      Absolute temperature
k :      Boltzmann constant
q :      Electron charge
$\phi_B$ :      Barrier height
n :      ideal factor

A forward voltage $V_F$ of the temperature detecting diode 72 and an ideal factor n thereof can be given based on an I-V characteristic of the temperature detecting diode 72. A temperature coefficient TC of the temperature detecting diode 7 is given by the following Formula 3.

$$TC \equiv \frac{\partial V_F}{\partial T} = \frac{nk}{q}\left(2 - \ln\frac{I_F}{SA^*T^2}\right) \qquad \dots\dots(3)$$

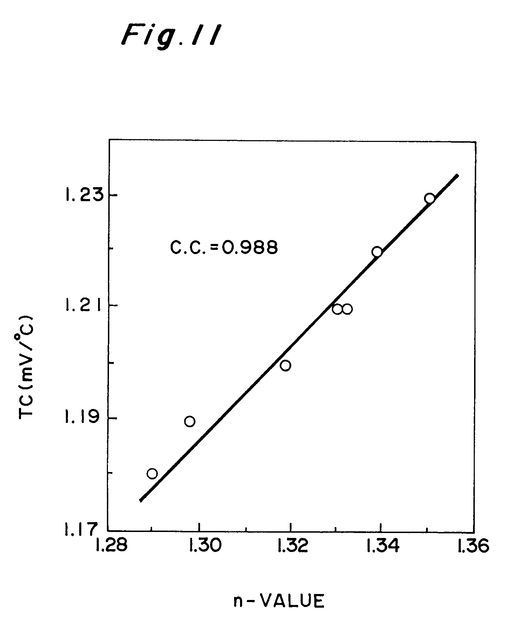

Variations of a value of the second term in the parentheses of Formula 3 are sufficiently small in the junction temperature range of burn-in tests, so that the TC value is almostly proportional to the n value. This relation between TC and n was confirmed by experiment result shown in FIG. 11.

A temperature coefficient TC of the forward voltage $V_F$ is given by Formula 1 and 2 (Step 202) to detect an accurate temperature of the semiconductor chip 7 during a burn-in. That is, semiconductor chips 7 are mounted on the burn-in apparatus, and while the integrated circuits 71 are in operation with a current supplied to, values of the forward voltages $V_F$ are measured (Step 203). Then, based on the value of the constant $V_{FO}$ given at the room temperature, the values of the forward voltages $V_F$ given real time during a burn-in, and a value of the ideal factor n, junction temperatures Tj of the temperature detecting diodes 72, i.e, surface temperatures of the semiconductor chips 7, are given real time (Step 204).

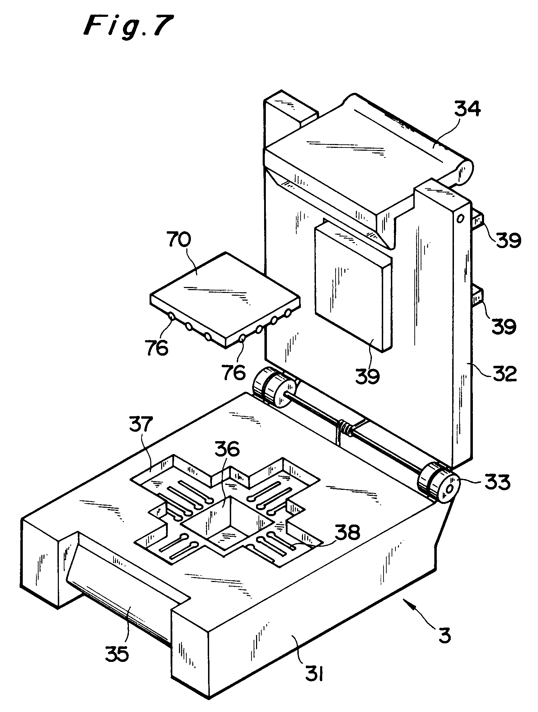

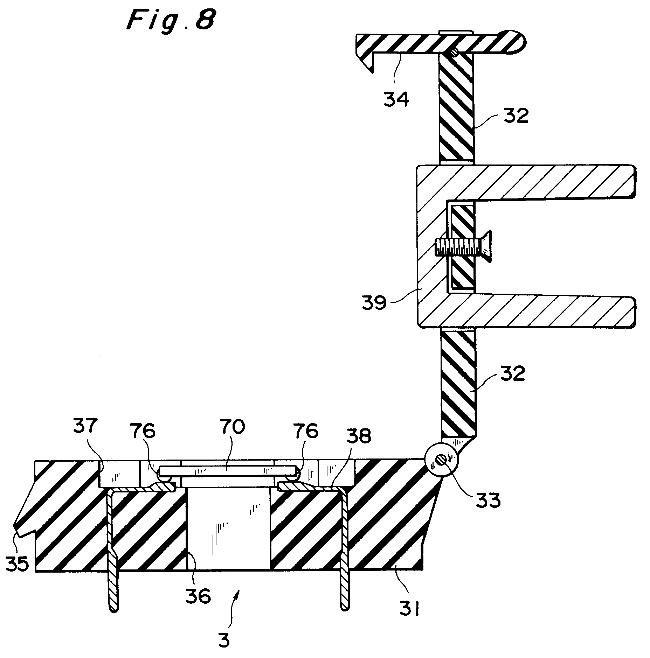

FIGs. 7 and 8 shows a way of mounting on a socket 3 the semiconductor device 70, which is a device to be tested, in the burn-in apparatus according to the above-described embodiment. FIG. 7 is a perspective view, and FIG. 8 is a sectional view. The socket 3 includes a base 31 and a lid 32 which are openably connected by a hinge 33 and locked by a lever 34 and hook 35. A through-hole 36 is formed in the central portion of the base 3, and a cross-shaped concavity 37 is formed on the upper surface of the central portion. Terminals 38 are provided in the concavity. One end of each terminals 38 is projected from the underside of the base 31 and is connected to the wiring on the burn-in board 1. To the central portion of the lid 32 there is secured a radiation member 39 by screws. On the other hand, a terminal 76 is provided on the underside of the semiconductor device 70, and when the semiconductor device 70 is mounted on the socket 3 to be brought into contact with the terminal 38 of the socket 3. When the semiconductor device 70 is set in the concavity 37, and the lide 32 is closed, the underside of the radiation member 39 is brought into contact with the top surface of the semiconductor device 70, and the radiation is enabled.

The control means 93 controls applying voltages of the power supplying means 91, and the temperature adjusting means 8, based on monitor results of the temperature detecting means 92. The control means 93 beforehand stores an allowable range of differences of the junction temperatures $T_{j1}$ - $T_{j3}$ for a burn-in test, and is programmed to compare the monitor results with the allowable range to control the power supplying means 91 and the temperature adjusting means 8, and ends a burn-in test operation when a temperature difference of the is outside the allowable range.

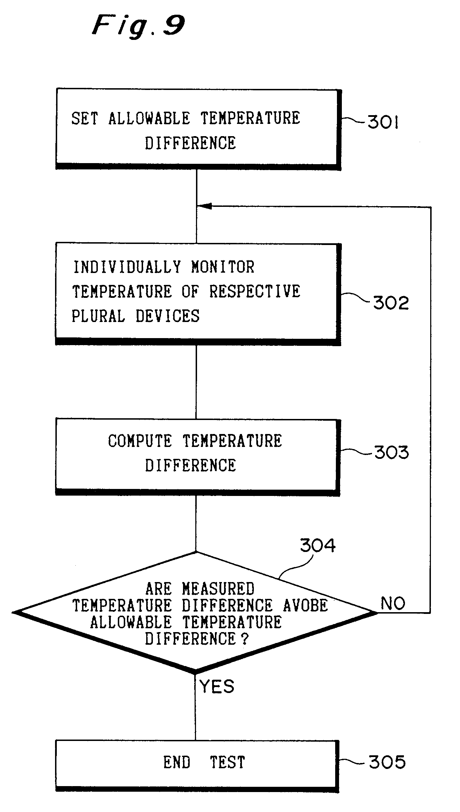

A first end control in the above-described burn-in test operation is explained in more detail in FIG. 9. An allowable temperature difference is set by an operator and stored by, e.g., a memory (Step 301). when a test is started, electric characteristics of a plurality of temperature detecting diodes $72_1$ - $73_3$ are measured, and junction temperatures $T_{j1}$ - $T_{j3}$ of the respective devices are individually monitored (Step 302). A temperature difference (a maximum temperature difference) among the devices is computed (Step 303), and this actually measured value and the set value in step 101 are compared (Step 304). The above-described steps are repeated until an actual measured value exceeds the set value (allowable value), and when the former exceeds the latter, the test is ended.

Thus, the reduction of a screening test is to a test for different purposes is prevented, and the test yield is improved. Specifically, since an environmental temperature Ta is not uniform inside the burn-in test chamber 6 where burn-in tests are conducted, depending on positions of heaters and air spouts, and directions of air flows and air flow rates, some devices have high temperatures, and others have low temperatures. In such case, according to this invention, the burn-in test is ended to secure the screening.

The control means 93 stores an allowable temperature range of junction temperatures $T_{j1}$ - $T_{j3}$ in a

5

burn-in test, and an allowable number of those of the semiconductor chips 7 whose junction temperatures are outside the allowable temperature range, and is programmed so as to compare monitor results with the allowable range or the allowable number, control the power supplying means 91 and the temperature adjusting means 8 and end the test operation when a number of those of the semiconductor chips whose temperatures are outside the allowable range has exceeded the allowable number. Thus screening can be secured.

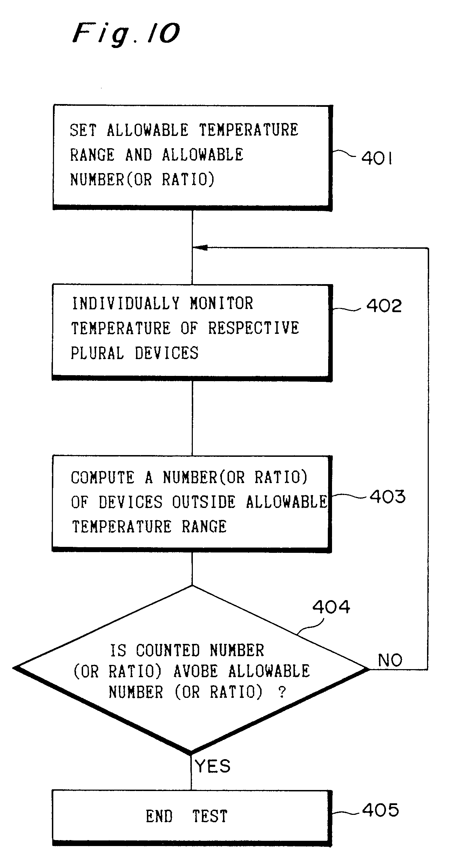

A second end control in the above-described burn-in test operation is explained in more detail in FIG. 10. First, an allowable temperature range, and an allowable number or ratio are set by an operator and is stored by, e.g., a memory (Step 401). When a test is started, electric characteristics of a plurality of temperature detecting diodes $72_1$ - $73_3$ are measured, and junction temperatures $T_{j1}$ - $T_{j3}$ of the respective devices are individually monitored (Step 402). Then, a number of those of the devices whose temperatures are outside the allowable temperature is counted, or a ratio of the number to a total number of the devices is computed (Step 403), and this actually measured value (number or ratio) is compared with the set value in Step 101 (Step 404). The above-described steps are repeated until an actually measured value exceeds the set value (allowable number or ratio), and when the former has exceeded the latter, the test is ended (Step 405). The temperature sensor used in this invention is not limited to the temperature detecting diode formed on a semiconductor chip separately from the integrated circuit 71, instead may use a diode of the integrated circuit, or may be a transistor. Otherwise a NiCr metal film resistor may be formed on the semiconductor chip. The temperature monitor may be conducted on all the semiconductor chips or on those of the semiconductors at positions where large differences in an environmental temperature are anticipated.

From the invention thus described, it will be obvious that the invention may be varied in many ways. Such variations are not to be regarded as a departure from the spirit and scope of the invention, and all such modifications as would be obvious to one skilled in the art are intended to be included within the scope of the following claims.

## Claims

1. A burn-in apparatus comprising:

mounting means for mounting devices-to-be-tested each including a semiconductor chip with a temperature sensor built in;

a test chamber for accommodating a plurality of the mounting means;

temperature adjusting means provided on the test chamber for adjusting an environmental temperature inside the test chamber;

temperature detecting means for individually measuring temperatures of the respective semiconductor chips, based on electric characteristics of the temperature sensors; and

control means for controlling the temperature adjusting means, based on measured results of the temperature detecting means.

2. A burn-in apparatus according to claim 1, further comprising power supplying control means added thereto the power supplying means being controlled by the control means of the burn-in apparatus.

3. A burn-in apparatus according to claim 1, wherein the temperature sensors are provided by Schottky junction diodes formed on the semiconductor chips.

4. A burn-in apparatus according to claim 1, wherein the temperature sensors are provided by pn junction diodes formed on the semiconductor chips.

5. A burn-in apparatus according to claim 1, wherein the temperature sensors are provided by transistors formed on the semiconductor chips.

6. A burn-in apparatus according to claim 1, wherein the temperature sensors are provided by metal film transistors formed on the semiconductor chips.

7. A burn-in test apparatus according to claim 1, wherein the mounting means are each provided by a printed board, and a plurality of sockets provided on the printed board.

8. A burn-in apparatus according to claim 1, wherein the test chamber includes a plurality of slits for receiving the mounting means in a casing with a lid, and connectors.

9. A burn-in apparatus according to claim 1, wherein the temperature detecting means applies various voltages to each of the temperature sensors to measure values of voltages for a specific value of current.

10. A burn-in apparatus according to claim 1, wherein, in accordance with a pre-stored processing procedure and a look up table, the control means receives the electric characteristics measured by the temperature detecting means, compute the same, and supplies operational instructions to the temperature adjusting means and the power supplying control means.

11. A burn-in apparatus according to claim 2, wherein the power supplying control means adjusts the presence and absence of current feed to the respective devices-to-be-tested, and applying voltages for the respective devices.

12. A burn-in method comprising:
the first step of deriving parameters for converting to junction temperatures electric characteristics of temperature sensors formed on respective semiconductor chips of devices-to-be-tested;
the second step of measuring junction temperatures of a pre-determined number of the semiconductor chips in the chamber using the parameters; and
the third step of adjusting the environmental temperature inside the test chamber, based on measurement results of junction temperatures,
following the third step, the second and the third steps being repeated.

13. A burn-in method according to claim 12, wherein said third step comprises a step of said third step comprising a process of controlling applying voltages to the respective devices to be tested.

14. A burn-in method according to claim 12, further comprising a step of ending the burn-in test when a test ending condition is detected.

15. A burn-in method according to claim 12, wherein the temperature sensors are Schottky junction diodes, the parameters for each temperature sensor for deriving a junction temperature thereof is an applied voltage at a specific junction temperature for causing a trifle current of a specific value to flow, and a temperature coefficient of the applied voltage, and the parameters are given by measuring at various environmental temperatures with the devices-to-be tested unfed for causing the trifle current of the specific value to flow.

16. A burn-in method according to claim 12, wherein the temperature sensors are Schottky diodes, parameters for each temperature sensor for deriving a junction temperature thereof are an applied voltage at a specific junction temperature for causing a trifle current to flow, and a value of n in the following Formula, and the parameters are given by measuring, with the devices-to-be-tested unfed, applied voltages at the room temperature for causing trifle currents of various values, and using a relationship expressed by the following Formula.

$$I_F \approx SA^*T^2 \exp\left(-\frac{q\phi_B}{kT}\right) \exp\left(\frac{qV_F}{nkT}\right)$$

$I_F$ : Forward current
$V_F$ : Forward voltage
S : Schottky junction area
$A^*$ : Effective Richardson constant
T : Absolute temperature
k : Boltzmann constant
q : Electron charge
$\phi_B$ : Barrier height

**17.** A burn-in method according to claim 12, wherein the temperature sensors are pn junction diodes, and the parameters for each temperature sensor for deriving a junction temperature thereof are an applied voltage at a specific junction temperature for a trifle current of a specific value to flow, and a temperature coefficient of the applied voltage, and the parameters are given by measuring, with the devices-to-be-tested unfed, applied voltages for causing the trifle current of the specific value to flow at various environmental temperatures.

**18.** A burn-in method according to claim 12, wherein the temperature sensors are transistors, parameters for deriving junction temperatures of the respective temperature sensors are an applied voltage at a specific junction temperature for causing a trifle current of a specific value, and a temperature coefficient of the applied voltage, and the parameters are given by measuring, with the devices-to-be-tested unfed, applied voltages for causing the trifle current of the specific value to flow at various environmental temperatures.

**19.** A burn-in method according to claim 12, wherein the temperature sensors are a metal film, and the parameters for deriving a junction temperature of each temperature sensor are an applied voltage at a specific junction temperature for causing a trifle current of a specific value to flow, and a temperature coefficient of the applied voltage, and the parameters are given by measuring, with the devices-to-be-tested unfed, applied voltages for causing the trifle current of the specific value to flow at various environmental temperatures.

**20.** A burn-in method according to claim 14, wherein a condition for ending a burn-in test is a difference between a maximum one of measured values of junction temperatures of the temperature sensors, and a minimum one thereof exceeds an allowable value.

**21.** A burn-in method according to claim 14, wherein a condition for ending a test is a number of those of the devices-to-be-tested whose junction temperatures exceed a set temperature range exceeds an allowable number.

**22.** A burn-in method according to claim 14, wherein a condition for ending a test is a ratio of those of the devices-to-be-tested whose junction temperatures exceed a set temperature range exceeds an allowable value.

Fig.1

*Fig.2*

6

63

62

64

65

3

5

1

61

EP 0 523 734 A1

Fig. 3

## *Fig.4A*

## *Fig.4B*

# Fig. 5

```
┌──────────────────────────────┐
│   MEASUREMENT OF Vᶠ AT        │ ~101
│   A VARIOUS TEMPERATURE       │
└──────────────────────────────┘

┌──────────────────────────────┐
│  DETERMINATION OF Vᶠₒ AND     │
│  TEMPERATURE COEFFICIENT(TC)  │ ~102
│  OF Vᶠ                        │
└──────────────────────────────┘

┌──────────────────────────────┐
│  MEASUREMENT OF Vᶠ UNDER      │ ~103
│  OPERATION OF SENSOR DIODES   │
└──────────────────────────────┘

┌──────────────────────────────┐
│   CALCULATION OF SURFACE      │
│   TEMPERATURE WITH            │ ~104
│   Vᶠₒ, Vᶠ AND TC-VALUE        │
└──────────────────────────────┘
```

## Fig. 6

```
┌─────────────────────────────────┐
│  MEASUREMENT OF $V_{F0}$ AND     │
│  n-VALUE FOR TEMPERATURE         │ ── 201
│  SENSOR DIODE AT R.T.            │
└─────────────────────────────────┘
                 │
┌─────────────────────────────────┐
│  DETERMINATION OF TEMPERATURE    │
│  COEFFICIENT(TC) OF $V_F$        │ ── 202
└─────────────────────────────────┘
                 │
┌─────────────────────────────────┐
│  MEASUREMENT OF $V_F$ UNDER      │
│  OPERATION OF SENSOR DIODES      │ ── 203
└─────────────────────────────────┘
                 │
┌─────────────────────────────────┐
│  CALCULATION OF SURFACE          │
│  TEMPERATURE WITH                │ ── 204
│  $V_{F0}$, $V_F$ AND TC-VALUE    │
└─────────────────────────────────┘
```

*Fig.7*

*Fig.8*

34
32
39
32
33
37 76 70 76 38
35
36
3
31

# Fig. 9

```
┌─────────────────────────────┐
│   SET ALLOWABLE TEMPERATURE  │ ~301
│          DIFFERENCE          │
└─────────────────────────────┘
               │
               │ ◄──────────────────┐
               ▼                    │
┌─────────────────────────────┐     │
│   INDIVIDUALLY MONITOR       │     │
│   TEMPERATURE OF RESPECTIVE  │ ~302│
│   PLURAL DEVICES             │     │
└─────────────────────────────┘     │
               │                    │
               ▼                    │
┌─────────────────────────────┐     │
│    COMPUTE TEMPERATURE       │ ~303│
│         DIFFERENCE           │     │
└─────────────────────────────┘     │
               │                    │
               ▼        304         │
           ◇─────────────◇          │
          ╱  ARE MEASURED  ╲        │
         ╱ TEMPERATURE DIFFERENCE ╲ │ NO
        ◇ AVOBE ALLOWABLE TEMPERATURE ◇───┘
         ╲    DIFFERENCE ?    ╱
          ╲─────────────────╱
               │ YES
               ▼
┌─────────────────────────────┐
│         END   TEST          │ ~305
└─────────────────────────────┘
```

# Fig. 10

```
┌─────────────────────────────┐
│ SET ALLOWABLE TEMPERATURE   │
│ RANGE AND ALLOWABLE         │ ── 401
│ NUMBER(OR RATIO)            │
└─────────────────────────────┘
              │
              ▼
┌─────────────────────────────┐
│ INDIVIDUALLY MONITOR        │
│ TEMPERATURE OF RESPECTIVE   │ ── 402
│ PLURAL DEVICES              │
└─────────────────────────────┘
              │
              ▼
┌─────────────────────────────┐
│ COMPUTE A NUMBER(OR RATIO)  │
│ OF DEVICES OUTSIDE ALLOWABLE│ ── 403
│ TEMPERATURE RANGE           │
└─────────────────────────────┘
              │
              ▼
         ╱────────╲              404
       ╱ IS COUNTED NUMBER ╲
      ╱  (OR RATIO) AVOBE    ╲   NO
      ╲  ALLOWABLE            ╱ ────
       ╲ NUMBER (OR RATIO) ? ╱
         ╲────────╱
              │ YES
              ▼
┌─────────────────────────────┐
│        END  TEST            │ ── 405
└─────────────────────────────┘
```

*Fig. 11*

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| Y | US-A-4 145 620 (DICE)<br>* column 1, line 26 - line 31 *<br>* column 1, line 51 - line 55 * | 1,4-9 | G01R31/28 |
| A | * column 2, line 9 - line 42 *<br><br>* column 4, line 1 - line 10 *<br>* column 4, line 21 - line 25 *<br>* column 4, line 24 - line 32 *<br>* column 5, line 4 - line 6; figures 1-3 * | 2,10,12,<br>15,17-19 | |
| Y | IBM TECHNICAL DISCLOSURE BULLETIN.<br>vol. 25, no. 7B, December 1982, NEW YORK US<br>page 3651<br>YU 'SELF-HEATING TEST CHIP FOR RELIABILITY TEST'<br>* the whole document * | 1,4,7-9 | |
| Y | INTERNATIONAL TEST CONFERENCE 1984 PROCEEDINGS 18 October 1984,<br>pages 400 - 423<br>BUSHANAM ET AL. 'MEASURING THERMAL RISES...'<br>* page 400, right column, paragraph 6 - page 403, right column, paragraph 3 * | 5 | |
| Y | US-A-4 734 641 (BYRD ET AL.)<br>* abstract; figures 1-3 * | 6 | |

TECHNICAL FIELDS SEARCHED (Int. Cl.5)

G01R

The present search report has been drawn up for all claims

| Place of search | Date of completion of the search | Examiner |
|---|---|---|
| THE HAGUE | 29 OCTOBER 1992 | IWANSSON K.G. |